# EUROPÄISCHE PATENTANMELDUNG

(11) **EP 4 800 416 A1**
(43) Veröffentlichungstag der Anmeldung: **02.09.2026**
(21) Anmeldenummer: 25160459.1
(22) Anmeldetag: 27.02.2025
(51) Int. Cl.: G01R 33/34

(54) **RUMPF-LOKALSPULENANORDNUNG**

(71) Anmelder: Siemens Healthineers AG, 91301 Forchheim (DE)
(72) Erfinder: Kimmlingen, Ralph, 90513 Zirndorf (DE); Schröder, Martin, 91096 Möhrendorf (DE)
(74) Vertreter: Siemens Healthineers Patent Attorneys

(57) **Zusammenfassung**

Die Erfindung betrifft eine Lokalspulenanordnung, einen Patiententisch und eine Magnetresonanzvorrichtung. Die Lokalspulenanordnung umfasst ein anteriores Teil, das eine Tragstruktur und eine anteriore Hochfrequenzsendeeinheit umfasst. Die Tragstruktur weist eine Auflageseite und eine, insbesondere der Auflageseite gegenüberliegende, Oberseite auf. Dabei ist die anteriore Hochfrequenzsendeeinheit an der Oberseite der Tragstruktur angeordnet. Die die Tragstruktur weist ein Innenvolumen aufweist, wobei das Innenvolumen ausgebildet ist, darin den Rumpfabschnitt des Patienten zu positionieren.

## Beschreibung

Die Erfindung betrifft eine Lokalspulenanordnung, einen Patiententisch und eine Magnetresonanzvorrichtung.

In der Medizintechnik zeichnet sich die Bildgebung mittels Magnetresonanz (MR), auch Magnetresonanztomographie (MRT, engl. Magnetic Resonance Imaging, MRI) genannt, durch hohe Weichteilkontraste aus. Hierbei werden mit Hilfe einer Magnetresonanzvorrichtung während einer Magnetresonanzmessung hochfrequente (HF, engl. radio-frequency, RF) Signale, insbesondere Pulse, zur Erzeugung eines HF-Feldes in einen Untersuchungsbereich, in dem sich ein zu untersuchender Patient befindet, eingestrahlt. Dadurch werden im Patienten orts kodierte Magnetresonanzsignale ausgelöst. Die Magnetresonanzsignale werden von der Magnetresonanzvorrichtung empfangen und zur Rekonstruktion von Magnetresonanzabbildungen verwendet.

Zur Signalanregung bei Magnetresonanzvorrichtungen mit ultrahohen Magnetfeldern, die beispielsweise mindestens 7 T betragen, kommen oftmals kombinierte HF-Sende-Empfangs-Lokalspulenanordnungen zum Einsatz. So sind beispielsweise ortsfeste Lokalspulenanordnungen bekannt, die für eine bestimmte Körperregion (z.B. Kopfspulen) eine optimierte Sende- und Empfangseffizienz bieten. Ein wichtiges Kriterium für die klinische Anwendung solcher Spulen ist einfache aber gleichzeitig präzise Handhabbarkeit, um insbesondere sicherzustellen, dass vorgegebene SAR-Grenzwerte nicht überschritten werden.

Ferner sind frei positionierbare Lokalspulenanordnungen bekannt, die mit frei verlegbaren Kabeln an die Magnetresonanzvorrichtung angeschlossen werden können. Ebenso ist die Verwendung von Positionierungshilfsmitteln wie beispielsweise Spanngurten bekannt. Solche Lösungen ermöglichen jedoch keinen standardisierten klinischen Workflow, sondern sind eher für Forschungsanwendungen geeignet, bei denen die Lokalspulenanordnung individuell an die Untersuchung angepasst werden kann.

Als Aufgabe der vorliegenden Erfindung kann angesehen werden, eine Lokalspulenanordnung zum Senden (und optional auch Empfangen) von HF-Signalen anzugeben, die den klinischen Workflow verbessert. Die Aufgabe wird durch die Merkmale der unabhängigen Ansprüche gelöst. Vorteilhafte Ausgestaltungen sind in den abhängigen Ansprüchen beschrieben.

Demnach wird eine Lokalspulenanordnung zur Magnetresonanzuntersuchung eines Rumpfabschnitts eines, insbesondere menschlichen, Patienten vorgeschlagen. Die Lokalspulenanordnung umfasst ein anteriores Teil, das eine Tragstruktur und eine anteriore Hochfrequenzsendeeinheit umfasst. Die Tragstruktur weist eine Auflageseite und eine, insbesondere der Auflageseite gegenüberliegende, Oberseite auf. Dabei ist die anteriore Hochfrequenzsendeeinheit an der Oberseite der Tragstruktur angeordnet. Die Tragstruktur weist ein Innenvolumen auf, wobei das Innenvolumen ausgebildet ist, darin den Rumpfabschnitt des Patienten zu positionieren.

Der Rumpf umfasst üblicherweise Brust, Bauch, Rücken und Becken des Patienten. Oftmals wird der Rumpf auch als Torso bezeichnet. Insbesondere kann unter dem Rumpf (im Sinne dieser Offenbarung) der Körperbereich oberhalb des Knies und unterhalb des Halses des Patienten verstanden werden. Der zu untersuchende Rumpfabschnitt ist ein Abschnitt des Rumpfs. Der Rumpfabschnitt kann einen Teil des Rumpfes oder den kompletten Rumpf umfassen. Bei der Untersuchung mittels der Lokalspulenanordnung muss also nicht notwendigerweise der komplette Rumpf untersucht werden, sondern die Untersuchung kann sich auch nur auf einen Abschnitt des Rumpfs beziehen. Ebenso muss nicht notwendigerweise der komplette Rumpf im Innenvolumen der Tragstruktur positioniert werden, sondern gegebenenfalls auch nur ein Abschnitt davon.

Das anteriores Teil ist insbesondere ein oberes Teil und/oder ein Oberteil. Bei bestimmungsgemäßer Verwendung der Lokalspulenanordnung ist das anteriore Teil ist insbesondere ganz oder teilweise über dem Rumpfabschnitt des Patienten angeordnet. Unter bestimmungsgemäßer Verwendung der Lokalspulenanordnung ist hier und im Folgenden insbesondere die Verwendung der Lokalspulenanordnung während einer Magnetresonanzmessung zu verstehen. Vorzugsweise befindet sich die Lokalspulenanordnung während der Magnetresonanzmessung in einem Untersuchungsbereich einer Magnetresonanzvorrichtung und/oder auf einem Patiententisch der Magnetresonanzvorrichtung. Insbesondere ist der Patient während der Magnetresonanzmessung auf dem Patiententisch gelagert.

Die anteriore Hochfrequenzsendeeinheit ist insbesondere ausgebildet, HF-Signale zu senden. Mit den gesendeten HF-Signale können beispielsweise Kernspins im Patienten, insbesondere im Rumpf des Patienten, angeregt werden. Durch eine Relaxation der Kernspin-Magnetisierung können Magnetresonanzsignale erzeugt werden, die als Messdaten von der Magnetresonanzvorrichtung akquiriert werden können.

Die anteriore Hochfrequenzsendeeinheit kann insbesondere eine oder mehrere Sendeantennen umfassen. Insbesondere kann jede Sendeantenne einem Sendekanal zugeordnet werden. Falls mehrere Sendeantennen bzw. Sendekanäle vorhanden sind, ist vorteilhafterweise eine parallele Sendetechnik (engl. parallel transmission, pTx) mit der Lokalspulenanordnung möglich.

Ferner ist denkbar, dass die Lokalspulenanordnung neben einer oder mehrerer Hochfrequenzsendeeinheiten, wie insbesondere der anterioren Hochfrequenzsendeeinheit, auch eine oder mehrere Hochfrequenzsendeeinheiten vom Empfangen von HF-Signalen, insbesondere Magnetresonanzsignalen umfasst.

Insbesondere ist die Auflageseite der Tragstruktur ausgebildet ist, auf einer Auflage angeordnet zu werden. Insbesondere ist die Auflageseite der Tragstruktur die Unterseite der Tragstruktur. Beispielsweise kann die Tragstruktur mit der Auflageseite nach unten auf die Auflage gelegt werden.

An der Auflageseite der Tragstruktur kann die Tragstruktur eine oder mehrere Auflageflächen und/oder Auflagepunkte aufweisen. Vorzugsweise berühren diese Auflageflächen und/oder Auflagepunkte die Auflage, wenn die Tragstruktur auf der Auflage angeordnet ist.

Die Tragstruktur ist vorzugsweise starr ausgebildet. Vorteilhafterweise ist ausgebildet, die anteriore Hochfrequenzsendeeinheit zu tragen und/oder zu stützen und/oder aufzunehmen. Die Tragstruktur kann aus einem oder mehreren Einzelteilen zusammengesetzt sein. Das Material der Tragstruktur kann beispielsweise einen Kunststoff, insbesondere glasfaserverstärkten Kunststoff (GFK) und/oder Polyvinylchlorid (PVC), umfassen. Vorteilhafterweise sorgte die starre Tragstruktur dafür, dass die anteriore Hochfrequenzsendeeinheit nicht einfach nur undefiniert auf dem Körper des Patienten aufliegt, sondern in einer definierten Weise relativ zum Patienten positioniert werden kann.

Vorzugsweise befindet sich das Innenvolumen der Tragstruktur zwischen der Auflageseite und der Oberseite der Tragstruktur. Vorzugsweise weisen die Auflageseite und die Oberseite einen Abstand voneinander auf, der groß genug ist, um den Rumpfabschnitt des Patienten dazwischen zu positionieren zu können. Vorteilhafterweise können mit der anterioren Hochfrequenzsendeeinheit von oben HF-Signale in den Rumpfabschnitt eingestrahlt werden.

Insbesondere begrenzt die Tragstruktur das Innenvolumen. Vorzugsweise ist das Innenvolumen der Tragstruktur in zumindest einer Richtung offen ausgebildet. Vorzugsweise ist das Innenvolumen der Tragstruktur an zwei gegenüberliegenden Stellen, insbesondere Enden, der Tragstruktur offen ausgebildet. Vorzugsweise ist das Innenvolumen der Tragstruktur senkrecht zur Transversalebene offen ausgebildet. Vorzugsweise wird das Innenvolumen der Tragstruktur senkrecht zur Transversalebene durch eine fußseitige Öffnung und/oder durch eine kopfseitige Öffnung begrenzt. Vorzugsweise ist das Innenvolumen der Tragstruktur derart offen ausgebildet, dass bei Verwendung der Lokalspulenanordnung durch eine fußseitige Öffnung des Innenvolumens sich ein fußseitiger Anteil des Körpers, beispielsweise der Unterkörper, des Patienten nach außen erstreckt, und/oder durch eine kopfseitige Öffnung des Innenvolumens sich ein kopfseitiger Anteil des Körpers, beispielsweise der Kopf, des Patienten sich nach außen erstreckt.

Bei dem Patienten wird vorzugsweise von einem erwachsenen menschlichen Patienten ausgegangen, beispielsweise einer Körpergröße von 150 bis 200 cm.

Die Transversalebene bezieht sich vorzugsweise die anatomische Ebene eines (typischen) Körpers des (menschlichen) Patienten, wenn dessen Rumpfabschnitt (bestimmungsgemäß) in der Lokalspulenanordnung positioniert ist. Dies gilt gleichermaßen auch für die Begriffe "Sagittalebene" und "Frontalebene", die im Folgenden verwendet werden. Wenngleich sich diese Begriffe zunächst auf die Anatomie des Patienten beziehen, können diese auf die vorgeschlagene Lokalspulenanordnung für deren Charakterisierung übertragen und/oder dafür (analog) verwendet werden, indem von einer bestimmungsgemäßen Positionierung des Patienten in der Lokalspulenanordnung ausgegangen wird. Die Transversalebene und/oder die Sagittalebene und/oder die Frontalebene entsprechen insbesondere der jeweiligen anatomische Ebene des Körpers des Patienten, wenn dieser bestimmungsgemäß in der Lokalspulenanordnung positioniert ist. Insbesondere beziehen sich die Frontalebene und/oder Sagittalebene und/oder die Transversalebene auf die Anatomie des Patienten, wenn dieser bestimmungsgemäß in der Lokalspulenanordnung positioniert ist. Eine bestimmungsgemäße Positionierung liegt vorzugsweise vor, wenn die Brust oder der Rücken des Patienten der Oberseite der Tragstruktur und/oder der anterioren Hochfrequenzsendeeinheit zugewandt ist.

Als Transversalebene wird üblicherweise eine Ebene bezeichnet, die senkrecht zur Längsachse des Patienten ausgerichtet ist. Die Längsachse des Patienten verbindet üblicherweise Kopf und Füße des Patienten.

Als Sagittalebene wird üblicherweise eine Ebene bezeichnet, die den Körper in eine rechte und eine linke Körperhälfte aufteilt. Beispielsweise umfassen die rechte Körperhälfte das rechte Bein und die linkte Körperhälfte das linke Bein des Patienten. Die Sagittalebene ist senkrecht zur Transversalebene ausgerichtet.

Als Frontalebene wird üblicherweise eine Ebene bezeichnet, die den Körper in einen vorderen und einen hinteren Anteil aufteilt. Beispielsweise umfasst der vordere Anteil den Bauch des Patienten und der hintere Anteil den Rücken des Patienten. Die Frontalebene ist senkrecht zur Transversalebene und/oder senkrecht zur Sagittalebene ausgerichtet. Beispielsweise ist der vordere Anteil des Patienten der Oberseite der Tragstruktur zugewandt. Eine mittig in der Lokalspulenanordnung angeordnete Ebene, die parallel zur Frontalebene ausgerichtet ist, trennt die Auflageseite der Tragstruktur von der Oberseite der Tragstruktur.

Vorzugsweise weist das Innenvolumen der Tragstruktur eine Länge, senkrecht zur Transversalebene, zwischen 50 bis 80 cm, insbesondere 60 bis 70 cm, auf. Vorzugsweise weist das Innenvolumen eine Breite, senkrecht zur Sagittalebene, zwischen 40 bis 70, insbesondere zwischen 50 bis 60, cm auf. Vorzugsweise weist das Innenvolumen eine Breite, senkrecht zur Frontalebene, zwischen 30 bis 60, insbesondere zwischen 40 bis 50 cm auf.

Vorzugsweise sind die Auflageseite der Tragstruktur und/oder die Oberseite der Tragstruktur parallel zu einer Frontalebene des Patienten ausgerichtet.

Vorzugsweise weist die Tragstruktur zwei Seitenabschnitte auf, die sich parallel zur Sagittalebene erstecken. Vorzugsweise wird das Innenvolumen der Tragstruktur senkrecht zur Sagittalebene durch die beiden Seiten Seitenabschnitte begrenzt.

Die Tragstruktur, insbesondere Seitenabschnitte der Tragstruktur, weist, insbesondere in einer Seitenansicht auf die Sagittalebene, eine C-Form, insbesondere eine Form eines C-Bogens, auf. Vorzugsweise ist die Sichtrichtung der Seitenansicht auf die Sagittalebene senkrecht auf die Sagittalebene ausgerichtet. Insbesondere kann jeweils ein rechter und ein linker Seitenabschnitt der Tragstruktur die C-Form aufweisen, so dass insbesondere von einem Doppel-C-Bogen gesprochen werden kann.

Vorzugsweise ist die C-Form der Tragstruktur durch eine, insbesondere längliche, Aussparung gekennzeichnet, die geeignet ist, darin zumindest teilweise einen Arm (insbesondere Oberarm, Unterarm und/oder Hand) und/oder eine Schulter des Patienten zu positionieren. Vorteilhafterweise erhält der Patient durch die Aussparung seitlich mehr Platz. Vorteilhafterweise kann somit der Komfort des Patienten bei einer Magnetresonanzuntersuchung mit der Lokalspulenanordnung erhöht werden.

Vorzugsweise umfasst die Lokalspulenanordnung eine Klemmschutzstruktur, die an der Aussparung angeordnet ist. Vorteilhafterweise kann durch die Klemmschutzstruktur verhindert werden, dass, insbesondere wenn die Lokalspulenanordnung zusammen mit dem Patienten auf einem Patiententisch bewegt wird, die Arme des Patienten eingeklemmt werden. Vorteilhafterweise verhindert die Klemmschutzstruktur, dass der Patient seinen Arm aus dem Innenvolumen der Tragstruktur herausbewegen kann.

Vorzugsweise ist die Klemmschutzstruktur flächig ausgebildet. Vorzugsweise erstreckt sich die Klemmschutzstruktur über einen Teil der durch die Aussparung ausgesparten Fläche. Vorzugsweise beträgt dieser Teil mehr als 50%, insbesondere mehr als 70 %, der der durch die Aussparung ausgesparten Fläche.

Vorzugsweise ist die Klemmschutzstruktur elastisch ausgebildet. Vorzugsweise weist die Klemmschutzstruktur eine mechanische Nachgiebigkeit auf. Vorteilhafterweise erhöht dies den Patientenkomfort.

Vorzugsweise ist die Klemmschutzstruktur als ein Gewebe, beispielsweise ein Textilgewebe, und/oder Netzes ausgebildet.

Vorteilhafterweise umfasst die Tragstruktur eine Verstellmechanik, wobei die anteriore Hochfrequenzsendeeinheit an der Verstellmechanik angeordnet ist, wobei die Verstellmechanik ausgebildet ist, die anteriore Hochfrequenzsendeeinheit, insbesondere um eine senkrecht zur Sagittalebene ausgerichtete Rotationsachse, zu kippen und/oder, insbesondere senkrecht zur Frontalebene, zu verschieben. Vorzugsweise ist die Verstellmechanik an der Oberseite der Tragstruktur angeordnet.

Zur Verschiebung kann die Verstellmechanik beispielsweise ein Führungssystem, insbesondere Schienen, umfassen. Zur Kippung kann die Verstellmechanik beispielsweise ein Drehsystem, insbesondere Drehgelenke und/oder Drehlager, umfassen. Die Drehgelenke und/oder Drehlager können beispielsweise an einem Rahmen der Verstellmechanik angeordnet sein.

Vorteilhafterweise kann durch die Verstellmöglichkeiten die Lokalspulenanordnung, insbesondere das anteriore Teil, besser an die Körperform des Patienten angepasst werden. Beispielsweise kann durch eine mögliche Verschiebung der Hochfrequenzsendeeinheit zum Patienten hin oder vom Patienten weg die Lokalspulenanordnung an den Körperumfang des Patienten angepasst werden. Vorteilhafterweise kann durch eine mögliche Kippung der Hochfrequenzsendeeinheit die Lokalspulenanordnung an das Körperprofil des Patienten angepasst werden.

Eine mögliche Ausführungsform der Lokalspulenanordnung sieht vor, dass die Lokalspulenanordnung ein posteriores Teil umfasst, wobei das posteriore Teil eine posteriore Hochfrequenzsendeeinheit umfasst, wobei die anteriore Teil, insbesondere die Tragstruktur ausgebildet ist, am posterioren Teil, insbesondere an der posterioren Hochfrequenzsendeeinheit, insbesondere reversibel, angeordnet zu werden. Vorteilhafterweise ist das anteriore Teil vom posterioren Teil abnehmbar.

Vorteilhafterweise kann zur Durchführung einer Magnetresonanzuntersuchung das posteriore Teil zunächst auf einem Patiententisch angeordnet werden. Dann man der Patient auf das posteriore Teil gelegt werden. Im Anschluss kann das anteriore Teil auf dem posterioren Teil angeordnet werden, so dass sich der Patient, insbesondere ein Rumpfabschnitt des Patienten, in dem Innenvolumen der Tragstruktur des anterioren Teils befindet.

Insbesondere ist die Tragstruktur ausgebildet, mit seiner Auflageseite am posterioren Teil, insbesondere an der posteriore Hochfrequenzsendeeinheit, angeordnet zu werden. Vorzugsweise sind bei einer Magnetresonanzuntersuchung des Rumpfabschnitts des Patienten die anteriore Hochfrequenzsendeeinheit und die posteriore Hochfrequenzsendeeinheit auf zwei gegenüberliegenden Seiten, insbesondere einer unteren und einer oberen Seite, der Tragstruktur angeordnet. Insbesondere weist die Tragstruktur Auflageflächen und/oder Auflagepunkte auf, die ausgebildet sind, am posterioren Teil, insbesondere an der posteriore Hochfrequenzsendeeinheit, angeordnet zu werden. Vorzugsweise umfasst das posteriore Teil eine Auflage zur Anordnung des anterioren Teils. Beispielsweise kann die Tragstruktur von oben auf das posteriore Teil gelegt werden.

Vorzugsweise weist das posteriore Teil eine zu den Auflageflächen und/oder Auflagepunkten korrespondierende Form auf. Vorzugsweise ist die Form des posterioren Teil ausgebildet, einen Formschluss mit dem anteriorem Teil, insbesondere an den Auflageflächen und/oder Auflagepunkte der Tragstruktur, herzustellen.

Das posteriore Teil ist insbesondere ein unteres Teil und/oder ein Unterteil. Vorzugsweise ist das posteriore Teil, insbesondere die posteriore Hochfrequenzsendeeinheit, ausgebildet, darauf den Rumpfabschnitt des Patienten zu lagern.

Vorzugsweise begrenzt das posteriore Teil das Innenvolumen der Tragstruktur, wenn das anteriore Teil an dem posteriore Teil (bestimmungsgemäß) angeordnet ist. Vorteilhafterweise begrenzen das posteriore Teil und das anteriore Teil das Volumen, in dem der Rumpfabschnitt des Patienten positioniert werden kann.

Die posteriore Hochfrequenzsendeeinheit kann insbesondere eine oder mehrere Sendeantennen umfassen. Insbesondere kann jede Sendeantenne einem Sendekanal zugeordnet werden. Falls die anteriore Hochfrequenzsendeeinheit und/oder die posteriore Hochfrequenzsendeeinheit zusammen mehrere Sendeantennen bzw. Sendekanäle aufweist, ist vorteilhafterweise eine parallele Sendetechnik (engl. parallel transmission, pTx) mit der Lokalspulenanordnung möglich.

Eine mögliche Ausführungsform der Lokalspulenanordnung sieht vor, dass die Tragstruktur zumindest ein anteriores Steckverbindungsteil umfasst, das an der Auflageseite der Tragstruktur angeordnet ist, wobei das posteriore Teil zumindest ein posteriores Steckverbindungsteil umfasst, wobei das zumindest eine anteriore Steckverbindungsteil und das zumindest eine posteriore Steckverbindungsteil ausgebildet sind, eine, insbesondere lösbare, Verbindung zur mechanischen Fixierung und/oder Signalübertragung herzustellen. Vorzugsweise erfolgt gleichzeitig mit einer Verbindung zur Signalübertragung auch eine Arretierung des anterioren Teils an dem posterioren Teil der Lokalspulenanordnung.

Vorteilhafterweise ist das zumindest eine posteriore Steckverbindungsteil ein zu dem zumindest einem anteriorem Steckverbindungsteil korrespondierendes posteriores Steckverbindungsteil. Beispielsweise fungiert das zumindest eine posteriore Steckverbindungsteil als zumindest eine Buchse Stecker und das zumindest eine anteriore Steckverbindungsteil als zumindest ein (dazu korrespondierender) Stecker. Beispielsweise fungiert das zumindest eine anteriore Steckverbindungsteil als zumindest eine Buchse Stecker und das zumindest eine posteriore Steckverbindungsteil als zumindest ein (dazu korrespondierender) Stecker.

Vorteilhafterweise bewirkt die mechanischen Fixierung eine mechanischen Fixierung des anterioren Teils an dem posterioren Teil. Vorzugsweise umfasst die mechanischen Fixierung eine Arretierung des anterioren Teils an dem posterioren Teil. Vorteilhafterweise wird die mechanische Fixierung mittels eines Formschlusses des anterioren Steckverbindungsteils mit dem posterioren Steckverbindungsteil hergestellt.

Vorteilhafterweise umfasst die Signalübertragung eine Übertragung von HF-Signalen, beispielsweise Sendesignalen (z.B. von HF-Sendepulsen) und/oder Empfangssignalen (z.B. Magnetresonanzsignalen). Die Signalübertragung kann insbesondere elektrisch, insbesondere mittels elektrischer Leiter, und/oder optisch, insbesondere mittels optischer Leiter erfolgen.

Eine mögliche Ausführungsform der Lokalspulenanordnung sieht vor, dass das anteriore Teil, insbesondere die Tragstruktur des anterioren Teils, und das posteriore Teil ausgebildet sind, in genau zwei verschiedenen Orientierungen miteinander mechanisch fixiert zu werden.

Die zwei verschiedenen Orientierungen sind insbesondere zwei zueinander entgegengesetzte Orientierungen. Die zwei verschiedenen Orientierungen sind insbesondere um 180° verdrehte Orientierungen. Vorzugsweise sind diese Orientierungen senkrecht zur Transversalebene ausgerichtet (+z-Richtung und -z-Richtung).

Vorzugsweise ist die Orientierung des posterioren Teil relativ zum Patiententisch, auf den der Patient positioniert wird, fest vorgegeben. (Insbesondere kann das posteriore Teil nur in einer bestimmten Ausrichtung auf dem Patiententisch angeordnet, insbesondere fixiert und/oder angeschlossen, werden.) Vorteilhafterweise kann dann auch die Orientierung des anterioren Teils relativ zum Patiententisch genau zwei verschiedene Zustände aufweisen. Vorzugsweise ist gegenüber dem einen Zustand ist die Orientierung des anderen Zustands um 180° verdreht.

Vorzugsweise umfasst das posterioren Teil genau zwei diagonal angeordnete posteriore Steckverbindungsteile und das anteriore Teil genau ein anteriores Steckverbindungsteil, wobei das anteriores Steckverbindungsteil in jedes der beiden posterioren Steckverbindungsteile steckbar ist und durch die diagonale Anordnung der posteriore Steckverbindungsteile genau zwei, insbesondere um 180° verdrehte, relative Ausrichtungen ermöglicht werden, um das anteriore Teil in das posteriore Teil zu stecken.

Vorzugsweise ist die Lokalspulenanordnung ausgebildet, eine Information über eine Orientierung, insbesondere in einem verbundenen Zustand, des anterioren Teiles relativ zu dem posterioren Teil auszugeben. Beispielsweise kann diese Information daraus abgeleitet werden, in welchem der beiden im vorangehenden Absatz beschriebenen diagonal angeordneten posterioren Steckverbindungsteilen das anteriore Steckverbindungsteil gesteckt ist.

Der verbundene Zustand ist insbesondere der Zustand, in dem eine Verbindung zwischen dem anterioren Teiles und dem posterioren Teil hergestellt ist. Der verbundene Zustand ist insbesondere der Zustand, in dem das zumindest eine posteriore Steckverbindungsteil mit dem zumindest einen anteriores Steckverbindungsteil verbunden ist.

Um die Information über die Orientierung auszugeben, kann beispielsweise ein Spulencode der Lokalspulenanordnung ausgelesen werden. Beispielsweise wird der Spulencode über zwei Leitungen übertragen. Vorzugsweise ist die Magnetresonanzvorrichtung ausgebildet, einen elektrischen Widerstand der Leitungen zu erfassen, über den die Orientierung ermittelt werden kann. Beispielsweise ist die Magnetresonanzvorrichtung ausgebildet, den erfassten elektrischen Widerstand über eine Nachschlagtabelle einen, insbesondere hexadezimalen, Code zuzuordnen, z.B. 0x0-0xF.

Vorzugsweise ist der erfassbare elektrische Widerstand abhängig von der Orientierung der Lokalspulenanordnung. Weist der elektrische Widerstand des anterioren Steckverbindungsteil bei fußseitiger Anordnung einen anderen Wert auf als bei kopfseitiger Anordnung. Vorteilhafterweise kann die Magnetresonanzvorrichtung dadurch erkennen, ob das anteriore Steckverbindungsteil fußseitig oder kopfseitig gesteckt wurde.

Vorzugsweise ist die Orientierung des Körpers relativ Orientierung der Lokalspulenanordnung fest vorgegeben. Wenn wiederum erkannt wird, in welcher Orientierung die Lokalspulenanordnung auf dem Patiententisch angeordnet ist, kann vorteilhafterweise auch die Orientierung des Körpers bestimmt werden. Beispielsweise kann eine Kopf-zuerst-Orientierung (engl. head first) von einer Fuß-zuerst-Orientierung (engl. feet first) unterschieden werden.

Eine mögliche Ausführungsform der Lokalspulenanordnung sieht vor, dass das posteriore Teil zumindest eine Verlängerungseinheit umfasst, wobei die zumindest eine Verlängerungseinheit ausgebildet ist, eine Erstreckung des posterioren Teils in der Frontalebene, insbesondere senkrecht zur Transversalebene, zu verlängern.

Vorzugsweise umfasst die Verlängerungseinheit ein Zwischenstück (insbesondere einen Abstandshalter und/oder Steckplatzadapter), das vorgesehen ist, zwischen einem, insbesondere festen, Anschlusspunkt am Patiententisch und der posterioren Hochfrequenzsendeeinheit angeordnet zu werden. Vorteilhafterweise kann die Verlängerungseinheit an dem Anschlusspunkt am Patiententisch fixiert und/oder mit dem Patiententisch verbunden werden.

Vorteilhafterweise kann mittels der Verlängerungseinheit der Abstand zwischen der posterioren Hochfrequenzsendeeinheit und dem Anschlusspunkt am Patiententisch eingestellt werden. Vorteilhafterweise können somit verschiedene Körperbereiche des Patienten besser mit Hilfe der Lokalspulenanordnung untersucht werden. Vorzugweise weist die Verlängerungseinheit eine Länge (senkrecht zur Transversalebene) von 10 bis 30 cm, insbesondere 20 cm auf. Vorteilhafterweise kann durch eine Verlängerungseinheit einer solchen Länge eine zweite Organposition (z.B. Herz) definiert werden. Wird die SAR-Überwachung (VOP oder K-Faktor) auf eine axiale Positionstoleranz von beispielsweise ±10 cm ausgelegt, sind vorteilhafterweise Organuntersuchungen am gesamten Oberkörper möglich.

Vorzugsweise umfassen die posteriore Hochfrequenzsendeeinheit und die zumindest eine Verlängerungseinheit eine (gemeinsame) Lokalspulenschnittstelle, die ausgebildet ist, Signale, insbesondere Sendesignale und/oder Empfangssignale, zu übertragen. Beispielsweise können von einer Steuereinheit der Magnetresonanzvorrichtung erzeugte Sendesignale, insbesondere Sendepulse, über die Lokalspulenschnittstelle übertragen werden. Beispielsweise können von der Lokalspulenanordnung empfangene Magnetresonanzsignale über die Lokalspulenschnittstelle an eine Auswerteeinheit der Magnetresonanzvorrichtung übertragen werden. Die Lokalspulenschnittstelle kann insbesondere eine Steckverbindung zur Signalübertragung umfassen.

Vorzugsweise ist die Lokalspulenschnittstelle ausgebildet, eine, insbesondere lösbare, Verbindung zur mechanischen Fixierung der posteriore Hochfrequenzsendeeinheit an der zumindest einen Verlängerungseinheit herzustellen. Die Fixierung kann insbesondere mittels eines Formschlusses, insbesondere einer Steckverbindung zur Signalübertragung, erfolgen.

Vorzugsweise ist die Lokalspulenschnittstelle ausgebildet, durch eine Bewegung des posterioren Teils relativ zur Verlängerungseinheit senkrecht zur Transversalebene die Verbindung herzustellen.

Ferner wird ein Patiententisch mit einer vorab beschriebenen Lokalspulenanordnung vorgeschlagen, wobei der Patiententisch eine Aufnahme zur Aufnahme der Lokalspulenanordnung, insbesondere zur Aufnahme eines posterioren Teils der Lokalspulenanordnung umfasst.

Vorzugsweise umfasst posteriore Hochfrequenzsendeeinheit und der Patiententisch eine (gemeinsame) Systemschnittstelle, die ausgebildet ist, Signale, insbesondere Sendesignale und/oder Empfangssignale, zu übertragen. Beispielsweise können von einer Steuereinheit der Magnetresonanzvorrichtung erzeugte Sendesignale, insbesondere Sendepulse, über die Systemschnittstelle übertragen werden. Beispielsweise können von der Lokalspulenanordnung empfangene Magnetresonanzsignale über die Systemschnittstelle an eine Auswerteeinheit der Magnetresonanzvorrichtung übertragen werden. Die Systemschnittstelle kann insbesondere eine Steckverbindung zur Signalübertragung umfassen.

Vorzugsweise ist die Systemschnittstelle ausgebildet, eine, insbesondere lösbare, Verbindung zur mechanischen Fixierung der Lokalspulenanordnung am Patiententisch herzustellen. Die Fixierung kann insbesondere mittels eines Formschlusses, insbesondere einer Steckverbindung zur Signalübertragung, erfolgen.

Vorzugsweise ist die Systemschnittstelle ausgebildet, durch eine Bewegung der Lokalspulenanordnung relativ zum Patiententisch senkrecht zur Transversalebene die Verbindung herzustellen.

Ferner wird eine Magnetresonanzvorrichtung mit einer vorab beschriebenen Lokalspulenanordnung vorgeschlagen. Die Vorteile der Magnetresonanzvorrichtung entsprechen im Wesentlichen den Vorteilen der vorab beschriebenen Lokalspulenanordnung. Hierbei erwähnte Merkmale, Vorteile oder alternative Ausführungsformen können ebenso auch auf die Magnetresonanzvorrichtung übertragen werden

Weitere Vorteile, Merkmale und Einzelheiten der Erfindung ergeben sich aus den im Folgenden beschriebenen Ausführungsbeispielen sowie anhand der Zeichnungen. Einander entsprechende Teile sind in allen Figuren mit den gleichen Bezugszeichen versehen.

Es zeigen:
- Fig. 1: eine Magnetresonanzvorrichtung mit einer Lokalspulenanordnung in einer schematischen Darstellung,
- Fig. 2: anatomische Ebenen zur Beschreibung von möglichen Merkmalen der Lokalspulenanordnung,
- Fig. 3: eine Lokalspulenanordnung auf einem Patiententisch,
- Fig. 4: eine Lokalspulenanordnung in einer ersten Anordnung auf dem Patiententisch,
- Fig. 5: eine Lokalspulenanordnung in einer zweiten Anordnung auf dem Patiententisch,
- Fig. 6: eine Lokalspulenanordnung mit einer Verlängerungseinheit in einer dritten Anordnung auf dem Patiententisch,
- Fig. 7: eine Lokalspulenanordnung mit einer verschiebbaren anterioren Hochfrequenzsendeeinheit,
- Fig. 8: eine Lokalspulenanordnung mit einer kippbaren anterioren Hochfrequenzsendeeinheit.

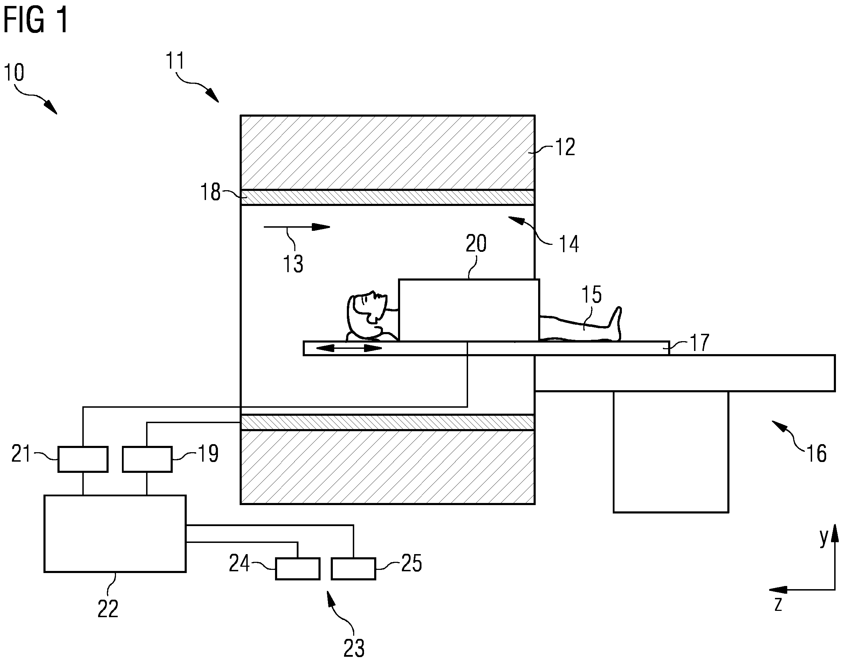

In Fig. 1 ist eine Magnetresonanzvorrichtung 10 schematisch dargestellt. Die Magnetresonanzvorrichtung 10 umfasst eine Magneteinheit 11, die einen Hauptmagneten 12 zu einem Erzeugen eines starken und insbesondere zeitlich konstanten Hauptmagnetfelds 13 aufweist. Zudem umfasst die Magnetresonanzvorrichtung 10 einen Patientenaufnahmebereich 14 zu einer Aufnahme eines Patienten 15. Der Patientenaufnahmebereich 14 im vorliegenden Ausführungsbeispiel ist zylinderförmig ausgebildet und in einer Umfangsrichtung von der Magneteinheit 11 zylinderförmig umgeben. Grundsätzlich ist jedoch eine davon abweichende Ausbildung des Patientenaufnahmebereichs 14 jederzeit denkbar. Der Patient 15 kann mittels einer Patientenlagerungsvorrichtung 16 der Magnetresonanzvorrichtung 10 in den Patientenaufnahmebereich 14 geschoben werden. Die Patientenlagerungsvorrichtung 16 weist hierzu einen innerhalb des Patientenaufnahmebereichs 14 insbesondere in z-Richtung bewegbar ausgestalteten Patiententisch 17 auf.

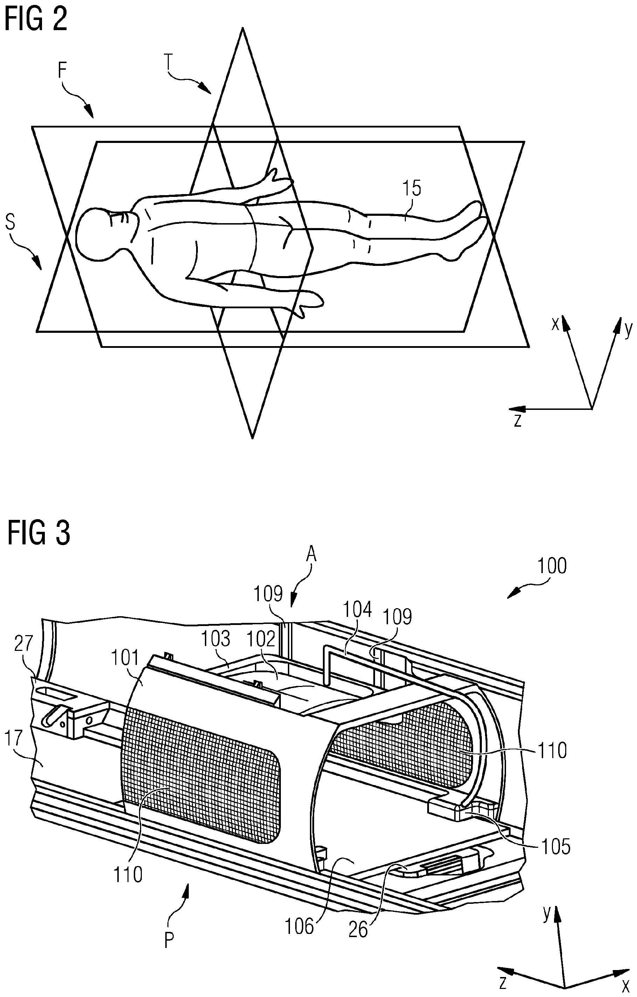

Die Magneteinheit 11 weist weiterhin eine Gradientenspuleneinheit 18 zu einer Erzeugung von Magnetfeldgradienten auf, die für eine Ortskodierung während einer Bildgebung verwendet werden. Die Gradientenspuleneinheit 18 wird mittels einer Gradientensteuereinheit 19 der Magnetresonanzvorrichtung 10 gesteuert. Die Magneteinheit 11 umfasst weiterhin eine Hochfrequenzantenneneinheit 20, welche im vorliegenden Ausführungsbeispiel als eine in den Fig. 3 bis 8 detailliert dargestellte Lokalspulenanordnung 100 ausgebildet ist. Die Hochfrequenzantenneneinheit 20 wird von einer Hochfrequenzantennensteuereinheit 21 der Magnetresonanzvorrichtung 10 gesteuert und strahlt hochfrequente Magnetresonanzsequenzen in einen Untersuchungsraum ein, der im Wesentlichen von einem Patientenaufnahmebereich 14 der Magnetresonanzvorrichtung 10 gebildet ist. Dadurch stellt sich dem von dem Hauptmagneten 12 erzeugten Hauptmagnetfeld 13 eine Anregung von Atomkernen ein. Durch Relaxation der angeregten Atomkerne werden Magnetresonanzsignale erzeugt. Die Hochfrequenzantenneneinheit 20 kann auch zum Empfang der Magnetresonanzsignale ausgebildet sein.

Zu einer Steuerung des Hauptmagneten 12, der Gradientensteuereinheit 19 und zur Steuerung der Hochfrequenzantennensteuereinheit 21 weist die Magnetresonanzvorrichtung 10 eine Systemsteuereinheit 22 auf. Die Systemsteuereinheit 22 steuert zentral die Magnetresonanzvorrichtung 10, wie beispielsweise das Durchführen einer vorbestimmten Magnetresonanzsequenz. Zudem umfasst die Systemsteuereinheit 22 eine nicht näher dargestellte Auswerteeinheit zu einer Auswertung der Magnetresonanzsignale, die während der Magnetresonanzuntersuchung erfasst werden. Des Weiteren umfasst die Magnetresonanzvorrichtung 10 eine Benutzerschnittstelle 23, die mit der Systemsteuereinheit 22 verbunden ist. Steuerinformationen wie beispielsweise Bildgebungsparameter, sowie rekonstruierte Magnetresonanzabbildungen können auf einer Anzeigeeinheit 24, beispielsweise auf zumindest einem Monitor, der Benutzerschnittstelle 23 für ein medizinisches Bedienpersonal angezeigt werden. Weiterhin weist die Benutzerschnittstelle 23 eine Eingabeeinheit 25 auf, mittels der Informationen und/oder Parameter während eines Messvorgangs von dem medizinischen Bedienpersonal eingegeben werden können.

Anhand von Fig. 2 sollen anatomische Ebenen des Patienten 15 verdeutlicht werden. Diese dienen auch der Beschreibung verschiedener möglicher Eigenschaften der anhand der folgenden Figuren beschriebenen Lokalspulenanordnung 200. Dabei wird davon ausgegangen, das der Patient 15 in einer bestimmungsgemäßen Weise (wie folgenden Figuren dargestellt; insbesondere auf dem Rücken oder auf dem Bauch liegend) in der Lokalspulenanordnung 200 positioniert ist. Entsprechend sind die anatomischen Ebenen des Patienten 15 auf die Lokalspulenanordnung 200, insbesondere den geometrischen Aufbau der Lokalspulenanordnung 200, zu übertragen.

Man unterscheidet eine Transversalebene T (parallel zur x-y-Ebene), eine Sagittalebene S (parallel zur y-z-Ebene) und eine Frontalebene F (parallel zur x-z-Ebene). Alle diese Ebenen sind senkrecht zueinander ausgerichtet. Die Transversalebene T ist senkrecht zur Längsachse des Patienten 15 ausgerichtet. Die Transversalebene T teilt den Körper des Patienten in eine Unterseite, beispielsweise seine Beine umfassend, und eine Oberseite, beispielsweise seine Oberkörper umfassend. Die Sagittalebene teilt den Körper des Patienten in eine linke und eine rechte Körperhälfte. Die Frontalebene F ist parallel zur Fläche, auf der der Patient 15 liegt. Die Frontalebene F teilt den Körper des Patienten 15 in eine Vorderseite und eine Rückseite.

Fig. 3 zeigt eine Lokalspulenanordnung 100 zur Magnetresonanzuntersuchung eines Rumpfabschnitts des Patienten 15 mit einem anterioren Teil A und einem posterioren Teil P. Das posteriore Teil P umfasst eine posteriore Hochfrequenzsendeeinheit 106 und ist auf dem Patiententisch 17 angeordnet. Beide Spulenteile A, B bilden vorteilhafterweise eine mechanische und elektrische Einheit, wodurch eine einfache und reproduzierbare Patientenpositionierung ermöglicht wird. Gleichzeitig ist sichergestellt, dass die Relativposition von Lokalspulenanordnung 100 und Patient 15 innerhalb vorhersagbarer Grenzen bleibt. Innerhalb dieser Grenzen können vorteilhafterweise SAR-Simulationen mit Menschmodell und Lokalspulenanordnung 100 sichere Dosiswerte vorgeben. Dies ist insbesondere für eine Anwendung einer freien pTx-Methode wichtig, um SAR-Hotspots für freie Sendephasen und -Amplituden möglichst genau abzuschätzen zu können.

Über eine Systemschnittstelle 26 ist das posteriore Teil P, insbesondere die posteriore Hochfrequenzsendeeinheit 106, mit der Magnetresonanzvorrichtung 10 verbunden. Über die Systemschnittstelle 26 können insbesondere Signale von der Magnetresonanzvorrichtung 10 an die Lokalspulenanordnung 100 und/oder von der Lokalspulenanordnung 100 an die Magnetresonanzvorrichtung 10 übertragen werden. Mittels der Systemschnittstelle 26 kann zudem die Lokalspulenanordnung 100 am Patiententisch 17 arretiert werden. Eine solche Direktsteckung der Lokalspulenanordnung 100 am Patiententisch ermöglicht (im Gegensatz zu einer etwaigen Steckung mittels frei verlegbarer Kabel) einen standardisierten klinischen Arbeitsablauf.

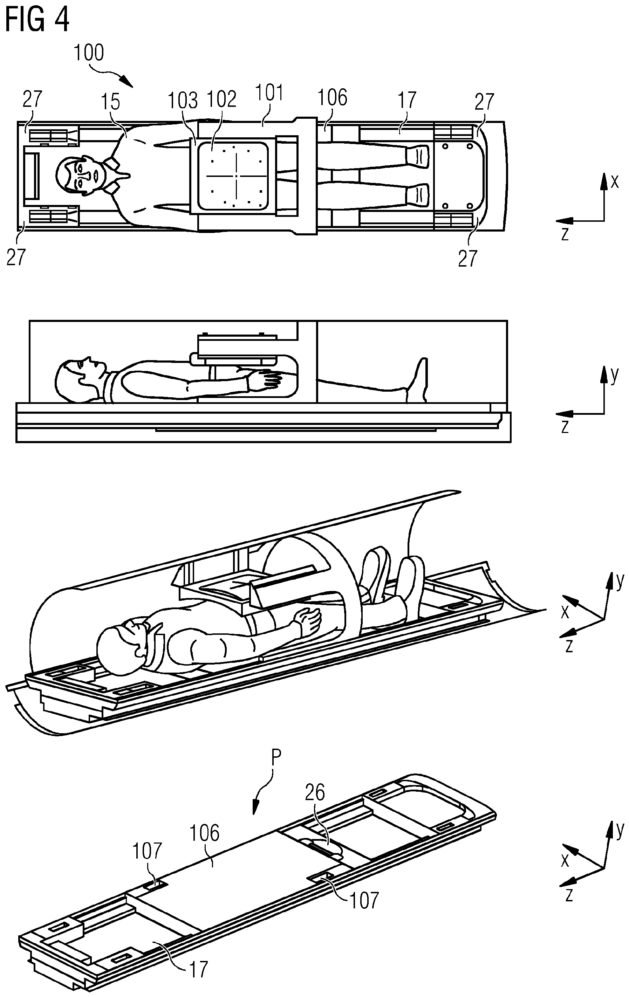

Das anteriore Teil A umfasst eine Tragstruktur 101 und eine anteriore Hochfrequenzsendeeinheit 102, die an der Oberseite der Tragstruktur 101 angeordnet ist. An der Auflageseite der Tragstruktur 101 ist die Tragstruktur 101 lösbar mit dem posterioren Teil P verbunden. Die Tragstruktur 101 weist ein Innenvolumen aufweist, in dem der zu untersuchende Rumpfabschnitt des Patienten 15 positioniert werden kann. Eine solche Positionierung des Patienten 15 im Innenvolumen der Tragstruktur 101 ist beispielhaft in den Fig. 4 bis 6 dargestellt, die jeweils (von oben nach unten) eine Draufsicht, eine Seitenansicht, eine perspektivische Ansicht von einer Lokalspulenanordnung 100 mit einem darin positionierten Patienten 15 sowie eine perspektivische Ansicht des posterioren Teils P zeigen.

Die Tragstruktur 101 weist beidseitig eine längliche Aussparung auf, an bzw. in der eine Klemmschutzstruktur 110 in Form eines Netzes oder Gewebes befestigt ist. Die Klemmschutzstruktur 110 erstreckt sich (im Wesentlichen) parallel zur Sagittalebene S. Vorteilhafterweise kann durch die Tragstruktur 101 verhindert werden, dass es zu Verletzungen, insbesondere Quetschungen kommt, wenn der Patient 15 auf dem Patiententisch 17 durch die Magneteinheit 11 der Magnetresonanzvorrichtung 10 verfahren wird.

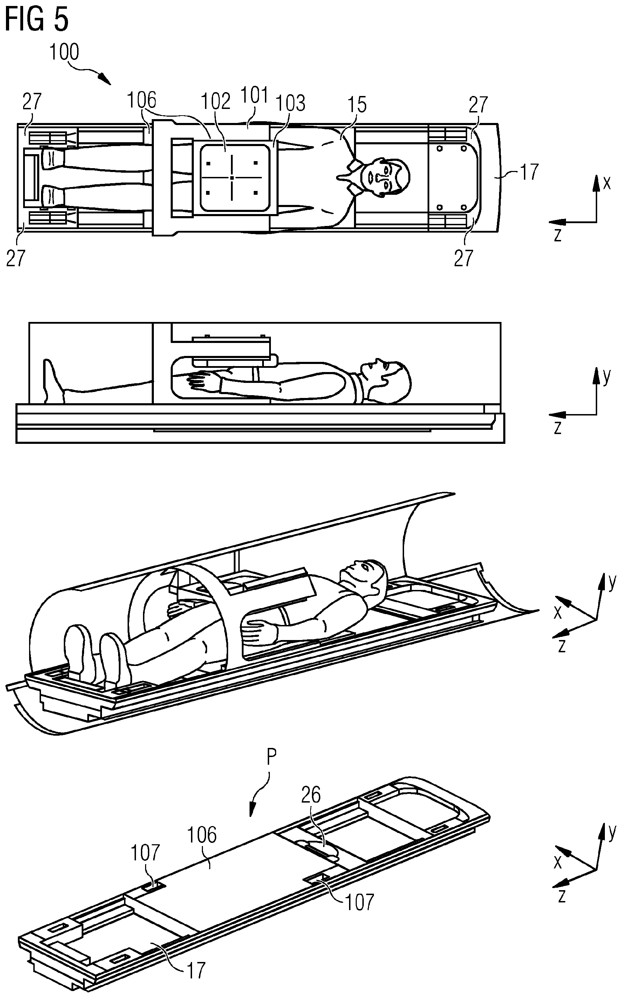

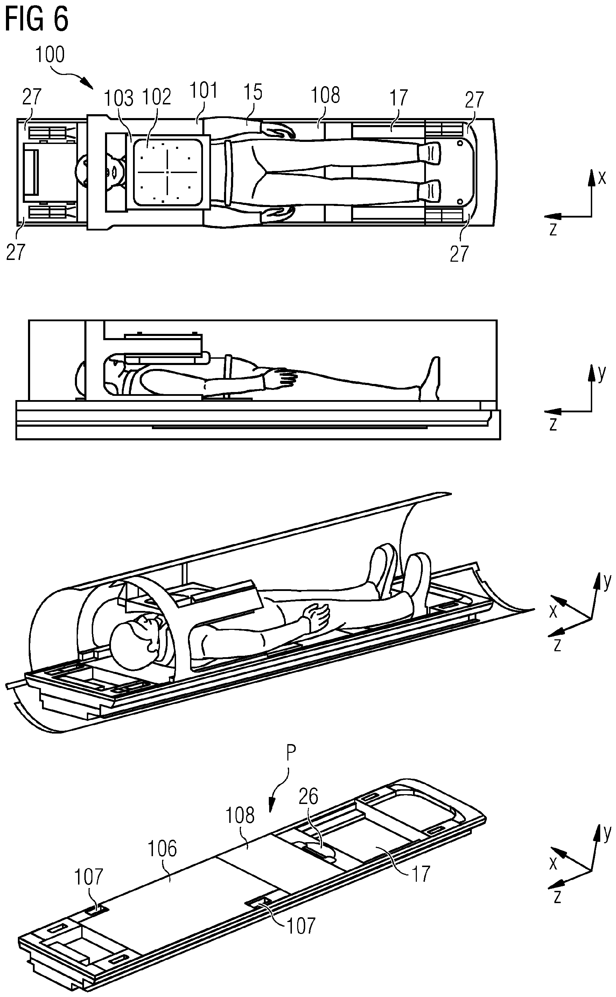

Der zu untersuchende Rumpfabschnitt ist gemäß Fig. 4 und 5 der Beckenbereich. Gemäß Fig. 6 wird der Brustbereich als Rumpfabschnitt untersucht. Dabei lagert der Patient 15 auf dem Patiententisch 17, wobei der zu untersuchende Rumpfabschnitt auf der posterioren Hochfrequenzsendeeinheit 106 gelagert ist.

Die Tragstruktur 101 umfasst ein anteriores Steckverbindungsteil 105, das an der Auflageseite der Tragstruktur 101 angeordnet ist. Das Steckverbindungsteil 105 ist mit der anterioren Hochfrequenzsendeeinheit 102 mittels einer Leitung 104, insbesondere elektrisch, verbunden.

Das posteriore Teil P umfasst zwei zum anterioren Steckverbindungsteil 105 korrespondierende posteriore Steckverbindungsteile 107, die in den Fig. 4 bis 6 gezeigt sind. In eines der beiden posterioren Steckverbindungsteile 107 wird das anteriore Steckverbindungsteil 105 gesteckt werden, um eine Verbindung zur mechanischen Fixierung und/oder Signalübertragung herzustellen.

Die beiden posterioren Steckverbindungsteil 107 sind an diagonal gegenüberliegenden Ecken der posterioren Hochfrequenzsendeeinheit 106 angeordnet. Dadurch kann die Tragstruktur 101 in genau zwei verschiedenen Orientierungen mit dem posterioren Teil P mechanisch fixiert werden. Dies ist beispielhaft in den Fig. 4 und 5 dargestellt: In Fig. 4 ist die Aussparung des Seitenabschnitts der Tragstruktur 101 in +z-Richtung geöffnet, in Fig. 5 in -z-Richtung, also um 180° verdreht. Vorteilhafterweise kann damit auch eine Positionserkennung (head first / feet first) beim Anschluss des anterioren Teils A an das posteriore Teils P ermöglicht werden.

In Fig. 6 umfasst das posteriore Teil P eine Verlängerungseinheit 108. Damit kann das posteriore Teil P in z-Richtung verlängert werden, d.h. die Erstreckung des posterioren Teils P wird senkrecht zur Transversalebene T verlängert. Da die Systemschnittstelle 26 ortsfest auf dem Patiententisch angeordnet ist, wird die posteriore Hochfrequenzsendeeinheit 106 um die Länge der Verlängerungseinheit 108 senkrecht zur Transversalebene T (hier in +z-Richtung) verschoben. Bei gleichbleibender Lage des Patienten 15 auf dem Patiententisch verschieben sich die Hochfrequenzsendeeinheiten 106, 107 der Lokalspulenanordnung 100 zu einem anderen Rumpfabschnitt des Patienten 15. So befinden sich die Hochfrequenzsendeeinheiten 106, 107 in gemäß Fig. 5 im Falle ohne Verlängerung im Beckenbereich des Patienten 15, während sie sich mit Verlängerung gemäß Fig. 6 im Brustbereich befinden.

Die Tragstruktur 101 ist starr ausgebildet, so dass sie die anteriore Hochfrequenzsendeeinheit 102 sicher tragen kann. Die Tragstruktur 101 umfasst an seiner Oberseite einen Rahmen 103, an dem die anteriore Hochfrequenzsendeeinheit 102 angeordnet ist. Die Tragstruktur weist Führungen 109 auf, in der der Rahmen 103 vertikal, d.h. senkrecht zur Frontalebene, verschoben werden kann. Die Tragstruktur 101 umfasst rechts und links jeweils einen Seitenabschnitt. Wenn man von der Seite auf die Sagittalebene S blickt, weisen die Seitenabschnitte jeweils eine C-Form auf. Wie in den Fig. 4 bis 6 zu erkennen ist, ist die C-Form der Tragstruktur 101 durch eine längliche Aussparung gekennzeichnet, in der zumindest teilweise ein Arm und/oder eine Schulter des Patienten 15 positioniert werden kann. Vorteilhafterweise entsteht für den Patienten 15 durch die doppelte C-Bogen-Struktur keine unnötige Einschränkung der Bewegungsfreiheit von Schulter, Armen oder Oberkörper.

Das Innenvolumen der Tragstruktur wird von unten durch die posterioren Hochfrequenzsendeeinheit 106, seitlich durch die Seitenabschnitte der Tragstruktur 101 und von oben durch die anteriore Hochfrequenzsendeeinheit 102 begrenzt.

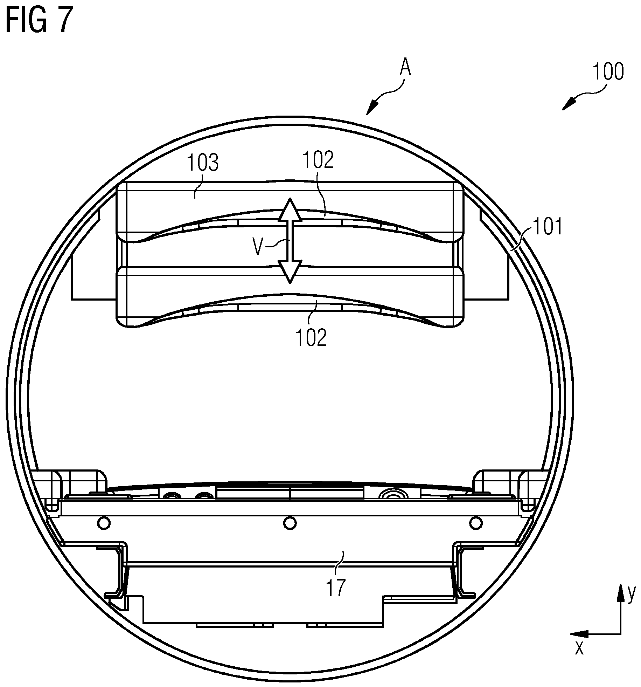

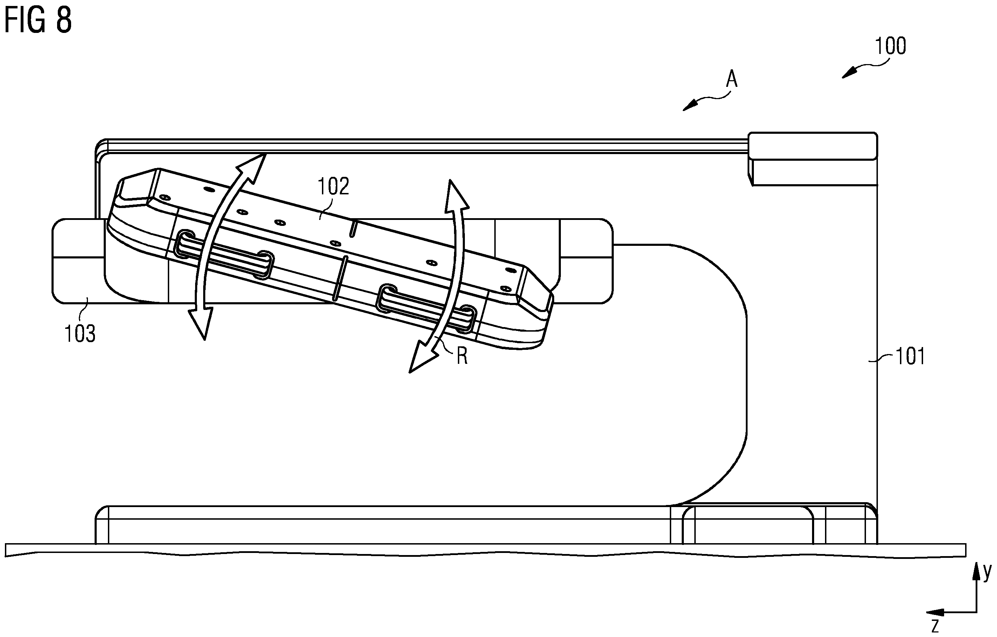

Der Rahmen 103 ist Teil einer Verstellmechanik der Tragstruktur 101. Mit Hilfe der Verstellmechanik kann die anteriore Hochfrequenzsendeeinheit 102 gekippt, insbesondere um eine senkrecht zur Sagittalebene S orientierte Rotationsachse, und/oder verschoben, insbesondere senkrecht zur Frontalebene F, werden. Dies ist im Detail in Fig. 7 und 8 dargestellt.

Um eine Verschiebung V gemäß Fig. 7 zu ermöglichen, umfasst die Tragstruktur 101 eine in Fig. 3 gezeigte Linearführung, in der der Rahmen 102 zusammen mit der anterioren Hochfrequenzsendeeinheit 102 vertikal verschoben werden kann.

Um eine Kippung R gemäß Fig. 8 zu ermöglichen, umfasst das anteriore Teil A zwischen dem Rahmen 103 und der anterioren Hochfrequenzeinheit 102 ein Drehgelenk, um das eine Rotation ausgeführt werden kann. Damit kann die Neigung der anterioren Hochfrequenzeinheit 102 gezielt eingestellt werden.

Die Lokalspulenanordnung 100 verbessert vorteilhafterweise den klinischen Einsatz einer Magnetresonanzuntersuchung des menschlichen Rumpfs. Bisherige Lösungen sind zwar oftmals einfach und flexibel, weisen aber gleichzeitig eine komplexe Handhabbarkeit und mangelnder Reproduzierbarkeit auf. Dies ist sowohl für klinische Reihenuntersuchungen, als auch für eine verlässliche (und gleichzeitig performante) SAR-Überwachung ein Problem.

Die vorgeschlagene Lokalspulenanordnung 100 ist vorteilhafterweise einfach handhabbar, da sie zusammen mit dem Spulenoberteil (mit insbesondere einstellbarer Höhe und Neigung) und dem Spulenunterteil (insbesondere mittels Steckverbindung und Formschluss) eine Einheit bildet. Durch die Führung der Leitung 104 innerhalb der Tragstruktur 101 können zudem etwaige Komplikationen durch freie Kabel vermieden vermiden. Durch die Einführung von zwei Steckmöglichkeiten ist es möglich, den Patienten 15 sowohl in "feet first"- als auch in "head first"-Position bequem zu positionieren. Die posteriore Hochfrequenzsendeeinheit 106 behält ihre Orientierung relativ zur Magneteinheit 11, wogegen die anteriore Hochfrequenzsendeeinheit 102 gemeinsam mit der Tragstruktur 101 um 180° gedreht wird. Gleichzeitig ist es dadurch möglich zu detektieren, welche Positionierung gewählt wurde (mechanische und/oder elektrische Kodierung der Steckplätze) und diese Information an die Systemsteuereinheit 22 zu übermitteln (z.B. via Coilcode-Leitung, welche individuelle Spulenparameter für die jeweilige Position bereitstellt, wie z.B. Sendephasen der Spulenelemente).

Es wird abschließend noch einmal darauf hingewiesen, dass es sich bei den vorhergehend detailliert beschriebenen Lokalspulenanordnung 100 bzw. der Magnetresonanzvorrichtung 10 um Ausführungsbeispiele handelt, welche vom Fachmann in verschiedenster Weise modifiziert werden können, ohne den Bereich der Erfindung zu verlassen. Weiterhin schließt die Verwendung der unbestimmten Artikel "ein" bzw. "eine" nicht aus, dass die betreffenden Merkmale auch mehrfach vorhanden sein können. Ebenso schließt der Begriff "Einheit" nicht aus, dass die betreffenden Komponenten aus mehreren zusammenwirkenden TeilKomponenten bestehen, die gegebenenfalls auch räumlich verteilt sein können. Unabhängig vom grammatikalischen Geschlecht eines bestimmten Begriffes sind Personen mit männlicher, weiblicher oder anderer Geschlechteridentität mit umfasst.

## Patentansprüche

1. Lokalspulenanordnung zur Magnetresonanzuntersuchung eines Rumpfabschnitts eines Patienten,
wobei die Lokalspulenanordnung ein anteriores Teil umfasst,
wobei das anteriore Teil eine Tragstruktur und eine anteriore Hochfrequenzsendeeinheit umfasst,
wobei die Tragstruktur eine Auflageseite und eine Oberseite aufweist,
wobei die anteriore Hochfrequenzsendeeinheit an der Oberseite der Tragstruktur angeordnet ist,
wobei die Tragstruktur ein Innenvolumen aufweist, wobei das Innenvolumen ausgebildet ist, darin den Rumpfabschnitt des Patienten zu positionieren.

2. Lokalspulenanordnung nach Anspruch 1,
wobei die Tragstruktur starr ausgebildet ist.

3. Lokalspulenanordnung nach einem der vorangehenden Ansprüche, wobei die Tragstruktur, insbesondere Seitenabschnitte der Tragstruktur, in einer Seitenansicht auf eine Sagittalebene eine C-Form aufweist.

4. Lokalspulenanordnung, wobei die C-Form der Tragstruktur durch eine, insbesondere längliche, Aussparung gekennzeichnet ist, die geeignet ist, darin zumindest teilweise einen Arm und/oder eine Schulter des Patienten zu positionieren.

5. Lokalspulenanordnung nach Anspruch 4,
wobei an der Aussparung eine, insbesondere elastische und/oder flächige, Klemmschutzstruktur angeordnet ist.

6. Lokalspulenanordnung nach einem der vorangehenden Ansprüche,
wobei die Tragstruktur eine Verstellmechanik umfasst,
wobei die anteriore Hochfrequenzsendeeinheit an der Verstellmechanik angeordnet ist,
wobei die Verstellmechanik ausgebildet ist, die anteriore Hochfrequenzsendeeinheit zu kippen, insbesondere um eine senkrecht zur Sagittalebene orientierte Rotationsachse, und/oder zu verschieben, insbesondere senkrecht zur Frontalebene.

7. Lokalspulenanordnung nach einem der vorangehenden Ansprüche,
wobei die Lokalspulenanordnung ein posteriores Teil umfasst,
wobei das posteriore Teil eine posteriore Hochfrequenzsendeeinheit umfasst,
wobei das anteriore Teil, insbesondere die Tragstruktur, ausgebildet ist, am posterioren Teil, insbesondere an der posteriore Hochfrequenzsendeeinheit, angeordnet zu werden.

8. Lokalspulenanordnung nach Anspruch 7,
wobei das posteriores Teil, insbesondere die posteriore Hochfrequenzsendeeinheit, ausgebildet ist, darauf den Rumpfabschnitt des Patienten zu lagern.

9. Lokalspulenanordnung nach einem der Ansprüche 7 oder 8,
wobei die Tragstruktur zumindest ein anteriores Steckverbindungsteil umfasst, das an der Auflageseite der Tragstruktur angeordnet ist,
wobei das posteriore Teil zumindest ein posteriores Steckverbindungsteil umfasst,
wobei das zumindest eine anteriore Steckverbindungsteil und das zumindest eine posteriore Steckverbindungsteil ausgebildet sind, eine Verbindung zur mechanischen Fixierung und/oder Signalübertragung herzustellen.

10. Lokalspulenanordnung nach einem der Ansprüche 7 bis 9,
wobei die Tragstruktur und das posteriore Teil ausgebildet sind, in genau zwei verschiedenen, insbesondere um 180° verdrehten, Orientierungen miteinander mechanisch fixiert zu werden.

11. Lokalspulenanordnung nach einem der Ansprüche 7 bis 10,
wobei die Lokalspulenanordnung ausgebildet ist, eine Information über eine Orientierung des anterioren Teiles relativ zu dem posterioren Teil auszugeben.

12. Lokalspulenanordnung nach einem der Ansprüche 7 bis 11,
wobei das posteriore Teil zumindest eine Verlängerungseinheit umfasst,
wobei die zumindest eine Verlängerungseinheit ausgebildet ist, eine Erstreckung des posterioren Teils senkrecht zur Transversalebene zu verlängern,
wobei die posteriore Hochfrequenzsendeeinheit und die zumindest eine Verlängerungseinheit optional eine Lokalspulenschnittstelle umfassen, die ausgebildet ist, Signale zu übertragen.

13. Patiententisch mit einer Lokalspulenanordnung nach einem der vorangehenden Ansprüche, wobei der Patiententisch eine Aufnahme zur Aufnahme der Lokalspulenanordnung, insbesondere zur Aufnahme eines posterioren Teils der Lokalspulenanordnung nach einem der Ansprüche 6 bis 12, umfasst.

14. Patiententisch nach Anspruch 13,
wobei die posteriore Hochfrequenzsendeeinheit und der Patiententisch eine Systemschnittstelle umfasst, die ausgebildet ist, Signale zu übertragen.

15. Magnetresonanzvorrichtung mit zumindest einer Lokalspulenanordnung nach einem der Ansprüche 1 bis 12 und/oder einem Patiententisch nach einem der Ansprüche 13 oder 14.
